(19) Europäisches Patentamt / European Patent Office / Office européen des brevets

(11) **EP 3 804 025 B1**

(12) **FASCICULE DE BREVET EUROPEEN**

(45) Date de publication et mention de la délivrance du brevet:
**05.07.2023 Bulletin 2023/27**

(21) Numéro de dépôt: **19740619.2**

(22) Date de dépôt: **22.05.2019**

(51) Classification Internationale des Brevets (IPC):
*H01P 5/103* (2006.01)   *H01P 5/12* (2006.01)
*H01J 37/32* (2006.01)

(52) Classification Coopérative des Brevets (CPC):
**H01J 37/32192; H01J 37/32201; H01J 37/32211; H01J 37/32229; H01J 37/32311; H01P 5/103; H01P 5/12**

(86) Numéro de dépôt international:
**PCT/FR2019/051167**

(87) Numéro de publication internationale:
**WO 2019/224481 (28.11.2019 Gazette 2019/48)**

(54) **DISPOSITIF COUPLEUR/COMBINEUR MICRO-ONDES ET GÉNÉRATEUR MICRO-ONDES ASSOCIÉ**

MIKROWELLENKOPPLER-/VERBINDER-GERÄT UND ZUGEHÖRIGEN MIKROWELLENGENERATOR

MICROWAVE COUPLER/COMBINER DEVICE AND RELATED MICROWAVE GENERATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.05.2018 FR 1854315**

(43) Date de publication de la demande:
**14.04.2021 Bulletin 2021/15**

(73) Titulaire: **Sairem Societe Pour L'application Industrielle De La Recherche En Electronique Et Micro Ondes 69150 Decines Charpieu (FR)**

(72) Inventeurs:
• **LATRASSE, Louis**
**69380 Dommartin (FR)**
• **GADEYNE, Thibault**
**01800 Meximieux (FR)**

(74) Mandataire: **Germain Maureau**
**12, rue Boileau**
**69006 Lyon (FR)**

(56) Documents cités:
WO-A1-2018/016071    CN-U- 202 749 491
CN-U- 202 977 681    CN-U- 205 406 695
GB-A- 781 882

**Description**

La présente invention se rapporte à dispositif coupleur/combineur micro-ondes pour un couplage et une combinaison d'au moins deux sources micro-ondes, ainsi qu'à un générateur micro-ondes comprenant des sources micro-ondes dont les puissances sont couplées et combinées au moyen d'un tel dispositif coupleur/combineur micro-ondes.

Elle se rapporte plus particulièrement à un dispositif coupleur/combineur micro-ondes pour combiner des puissances micro-ondes issues de plusieurs sources micro-ondes, et en particulier à un dispositif coupleur/combineur micro-ondes avec des transitions coaxial/guide d'ondes et adapté pour des sources micro-ondes à état solide (ou générateurs micro-ondes à transistors).

De manière classique, il est connu d'employer des magnétrons pour générer des micro-ondes, qui présentent l'avantage de procurer de fortes puissances micro-ondes. Ces magnétrons émettent des micro-ondes à une fréquence donnée qui est fixe, à puissance fixe et à température (ou refroidissement) fixe. Cependant, une telle fréquence est généralement peu stable et donc peu maitrisée, suivant par exemple les variations de puissance, de température de l'air ambiant, de température de l'eau de refroidissement, etc.

Il est également connu d'employer des générateurs micro-ondes à état solide (ou générateurs micro-ondes à transistors) qui pallient le principal défaut du magnétron, en permettant d'émettre des micro-ondes à une fréquence contrôlée, et même de faire varier de manière précise la fréquence en faisant varier la fréquence de l'oscillateur qui les pilote au moyen d'un système de réglage fréquentiel.

Cependant, les générateurs micro-ondes à état solide, qui permettent de sortir de la puissance sur des câbles coaxiaux, sont assez limités en puissance, notamment de l'ordre de quelques centaines de watts dans le domaine des micro-ondes. Par ailleurs, la puissance des générateurs micro-ondes à état solide s'auto limite dans le sens ou la sortie coaxiale a elle-même une limitation en puissance, de par sa conception même.

Ainsi, pour augmenter la puissance disponible avec une technologie à état solide, il convient de combiner la puissance de plusieurs générateurs micro-ondes à état solide ayant des sorties coaxiales.

Il est ainsi connu du document CN 205 406 695 U d'employer un dispositif coupleur/combineur micro-ondes comprenant un guide d'ondes et plusieurs connecteurs coaxiaux monté extérieurement sur le guide d'ondes, sans explication détaillée sur la mise en oeuvre d'un couplage entre le guide d'ondes et chaque connecteur coaxial.

L'état de la technique peut également être illustré par l'enseignement du document CN 202 977 681, qui divulgue un dispositif coupleur/combineur micro-ondes comprenant un guide d'ondes et plusieurs connecteurs coaxiaux montés extérieurement sur le guide d'ondes, avec des sondes coaxiales employées pour effectuer un couplage des puissances micro-ondes issues des connecteurs coaxiaux. Avec de telles sondes coaxiales, la propagation et la combinaison des puissances micro-ondes issues de deux connecteurs coaxiaux en vis-à-vis s'effectuent dans l'axe commun à ces connecteurs coaxiaux et à la sonde coaxiale concernée, et donc conduit à une dissipation thermique inefficace qui va au détriment des valeurs de puissances que l'on peut combiner.

L'état de la technique peut également être illustré par les enseignements de WO 2018/016071 qui propose un dispositif de couplage permettant de coupler deux connecteurs coaxiaux au moyen de deux barres longitudinales respectives séparées l'une de l'autre.

Il est également connu de GB 781 882 un dispositif de transition entre une ligne coaxiale et un guide d'ondes, mettant en oeuvre une barre disposée dans le guide d'ondes et reliée à un connecteur coaxial.

L'art antérieur s'illustre aussi avec le document CN 202749491 qui propose un dispositif de couplage permettant de coupler deux connecteurs coaxiaux au moyen de deux éléments de couplage séparés l'un de l'autre.

La présente invention a donc pour but de proposer un dispositif coupleur/combineur micro-ondes qui permet de combiner les puissances de plusieurs sources micro-ondes, et notamment de plusieurs sources micro-ondes à état solide.

Un autre but de l'invention est de proposer un dispositif coupleur/combineur micro-ondes qui offre un encombrement réduit, et donc qui permet de délivrer une grande puissance micro-ondes (en sortie du dispositif coupleur/combineur micro-ondes) tout en étant compact.

Un autre but de l'invention est de proposer un dispositif coupleur/combineur micro-ondes qui permet de combiner les puissances de plusieurs sources micro-ondes tout en améliorant la dissipation de chaleur nécessairement produites avec cette combinaison de puissances.

Un autre but de l'invention est de proposer un dispositif coupleur/combineur micro-ondes adapté aux micro-ondes dans les bandes de fréquences micro-ondes d'usage industriel, scientifique et médical (ISM) attribuées par l'Union internationale des télécommunications (UIT), et notamment les bandes de fréquences micro-ondes 2,450 GHz $\pm$ 50,0 MHz, 5,800 GHz $\pm$ 75,0 MHz, 433,92 MHz $\pm$ 0,87 MHz, 896 MHz $\pm$ 10 MHz et 915 MHz $\pm$ 13 MHz.

A cet effet, elle propose un dispositif coupleur/combineur micro-ondes pour un couplage et une combinaison d'au moins deux sources micro-ondes, comprenant un guide d'ondes muni de :

- un manchon s'étendant longitudinalement selon un axe principal et présentant deux extrémités opposées comprenant une première extrémité munie d'un élément formant court-circuit et une seconde extrémité ouverte ; et

- au moins une barre transversale s'étendant à l'intérieur du manchon selon un axe transversal orthogonal à l'axe principal ;

ledit dispositif coupleur/combineur micro-ondes comprenant en outre au moins deux connecteurs coaxiaux prévus pour être respectivement connectés à des sources micro-ondes,

dans lequel chaque connecteur coaxial est monté extérieurement sur le manchon et présente une âme centrale conductrice reliée à et prolongée par une antenne conductrice s'étendant à l'intérieur du manchon conducteur et se terminant par une extrémité fixée sur une barre transversale, où ladite âme centrale conductrice et ladite antenne conductrice sont alignées et s'étendent selon une direction orthogonale à l'axe transversal et à l'axe principal.

Ainsi, l'invention propose de combiner les puissances de plusieurs sources micro-ondes, et notamment de plusieurs sources micro-ondes à état solide, ayant une sortie coaxiale, afin de générer une puissance de sortie micro-ondes accrue, tout en offrant une configuration compacte.

Dans l'invention, les au moins deux connecteurs coaxiaux comprennent deux connecteurs coaxiaux contigus dont les antennes conductrices sont fixées sur une même barre transversale, ces connecteurs coaxiaux contigus étant disposés côte à côte selon une direction parallèle à l'axe transversal de la barre transversale, ledit plan de symétrie incluant également un axe secondaire à la fois orthogonal à l'axe principal et à l'axe transversal d'une barre transversale.

Selon une caractéristique, les deux connecteurs coaxiaux contigus sont disposés symétriquement de part et d'autre d'un plan de symétrie du manchon incluant l'axe principal.

Dans une deuxième réalisation, le guide d'ondes comprend au moins une barre transversale proximale et une barre transversale distale parallèles et décalées l'une de l'autre selon l'axe principal, et les au moins deux connecteurs coaxiaux comprennent au moins un connecteur coaxial proximal dont l'antenne conductrice est fixée sur la barre transversale proximale et au moins un connecteur coaxial distal dont l'antenne conductrice est fixée sur la barre transversale distale.

Selon une caractéristique, le connecteur coaxial proximal et le connecteur coaxial distal sont décalés l'un de l'autre selon une direction parallèle à l'axe principal.

Dans une réalisation particulière combinant la première réalisation et la deuxième réalisation, les au moins deux connecteurs coaxiaux comprennent :

- deux connecteurs coaxiaux contigus proximaux dont les antennes conductrices sont fixées sur la barre transversale proximale ; et
- deux connecteurs coaxiaux contigus distaux dont les antennes conductrices sont fixées sur la barre transversale distale.

Dans une troisième réalisation, le guide d'ondes comprend au moins une barre transversale supérieure et une barre transversale inférieure parallèles et décalées l'une de l'autre selon un axe secondaire à la fois orthogonal à l'axe principal et aux axes transversaux desdites barres transversales de sorte que la barre transversale supérieure et la barre transversale inférieure s'étendent dans un plan commun orthogonal à l'axe principal, et les au moins deux connecteurs coaxiaux comprennent au moins un connecteur coaxial supérieur monté sur une face supérieure du manchon et dont l'antenne conductrice est fixée sur la barre transversale supérieure et au moins un connecteur coaxial inférieur monté sur une face inférieure du manchon et dont l'antenne conductrice est fixée sur la barre transversale inférieure, et dans lequel le connecteur coaxial inférieur et le connecteur coaxial supérieur s'étendent dans le plan commun.

Selon une caractéristique, l'antenne conductrice du connecteur coaxial inférieur et l'antenne conductrice du connecteur coaxial supérieur sont alignées.

Dans une réalisation particulière combinant la première réalisation et la troisième réalisation, les au moins deux connecteurs coaxiaux comprennent :

- deux connecteurs coaxiaux contigus supérieurs dont les antennes conductrices sont fixées sur la barre transversale supérieure ; et
- deux connecteurs coaxiaux contigus inférieurs dont les antennes conductrices sont fixées sur la barre transversale inférieure.

Avantageusement, la au moins une barre transversale est réalisée dans un matériau ayant une conductivité thermique d'au moins 100 W/(m.K).

Dans un mode de réalisation particulier, la au moins une barre transversale est réalisée dans un matériau à base de l'un au moins des métaux suivants : cuivre, laiton, aluminium, or et argent.

Selon une possibilité de l'invention, la au moins une barre transversale est creuse.

Selon une autre possibilité de l'invention, un liquide de refroidissement est mis en circulation à l'intérieur de la au moins une barre transversale creuse.

Conformément à une autre caractéristique avantageuse de l'invention, en considérant des sources micro-ondes émettant des micro-ondes à une même fréquence $f_0$ et une même longueur d'onde $\lambda_0$ données, la au moins une barre transversale est disposée à une longueur L donnée de l'élément formant court-circuit, selon l'axe principal, avec :

$$L = Lc + k.Lg/2,$$

où

k est un entier nul ou positif ;
Lc = p.$\lambda$g/4;
Lg = $\lambda$g $\pm$ 10 %;
$\lambda$g correspond à la longueur d'onde guidée des micro-ondes à l'intérieur du guide d'ondes, qui dépend des dimensions du guide d'ondes ;
p est un coefficient de correction inférieur à 1.

En effet, le générateur micro-ondes émet des micro-ondes avec une fréquence $f_0$ et une longueur d'onde $\lambda_0$. A l'intérieur du guide d'ondes, les micro-ondes conservent la fréquence $f_0$ mais la longueur d'onde sera $\lambda$g, la longueur d'onde guidée à l'intérieur du guide d'ondes, qui dépend des dimensions du guide d'ondes.

Ensuite, d'un point de vue théorique, si la ou les antennes conductrices et la ou les barres transversales ont des diamètres nuls, alors on aura Le = $\lambda$g/4 et Lg = $\lambda$g. Or, comme les antennes conductrices et les barres n'ont pas des diamètres nuls et qu'elles sont assez grosses afin transmettre les calories, alors la longueur Le est inférieure à $\lambda$g/4, et plus précisément on aura Le = p.$\lambda$g/4, où p est un coefficient de correction qui tient compte de la correction due aux perturbations des antennes conductrices. Par ailleurs, la longueur Lg est variable autour de $\lambda$g, selon les perturbations indues par la ou les antennes conductrices et la ou les barres transversales, et donc on aura Lg = $\lambda$g $\pm$ 10 %.

Dans le cadre de la deuxième réalisation, il est avantageux que la barre transversale proximale et la barre transversale distale sont disposées à des longueurs respectives Lprox et Ldist données de l'élément formant court-circuit, selon l'axe principal, avec :

$$Lprox = Lc + kprox.Lg/2,$$

où kprox entier nul ou positif

$$Ldist = Lc + kdist.Lg/2,$$

où kdist entier positif supérieur à kprox ; de sorte que la barre transversale proximale et la barre transversale distale sont décalées l'une de l'autre selon l'axe principal d'un écartement EC tel que :

$$EC = Ldist - Lprox = (kdist - kprox).Lg/2 = N.Lg/2$$

où N entier positif

Dans une réalisation particulière, EC = Lg/2 avec :

- soit kprox = 0 et kdist = 1,
- soit kprox = 1 et kdist = 2

La présente invention concerne également la caractéristique selon laquelle, pour chaque connecteur coaxial, l'extrémité de l'antenne conductrice présente un diamètre inférieur, supérieur ou égal à un diamètre de la barre transversale sur laquelle elle est fixée.

Dans une réalisation particulière et non limitative, pour chaque connecteur coaxial, l'extrémité de l'antenne conductrice présente un diamètre équivalent à 15% près à un diamètre de la barre transversale sur laquelle elle est fixée.

Selon une caractéristique, pour chaque connecteur coaxial, l'âme centrale présente un diamètre inférieur, ou inversement supérieur, au diamètre de la barre transversale correspondante, et l'antenne conductrice présente un diamètre croissant, ou inversement décroissant, progressivement à partir de l'âme centrale jusqu'à atteindre un diamètre équivalent à 15% près au diamètre de la barre transversale.

L'invention se rapporte également à un générateur micro-ondes comprenant :

- au moins deux sources micro-ondes émettant des micro-ondes à une même fréquence $f_0$ et une même longueur d'onde $\lambda_0$ données ; et
- un dispositif coupleur/combineur micro-ondes comme décrit ci-avant ;

et dans lequel les sources micro-ondes sont connectées respectivement aux connecteurs coaxiaux du dispositif coupleur/combineur micro-ondes.

Selon une possibilité, le dispositif coupleur/combineur micro-ondes comprend deux connecteurs coaxiaux contigus dont les antennes conductrices sont fixées sur une même barre transversale, ces connecteurs coaxiaux contigus étant disposés côte à côte selon l'axe transversal de la barre transversale, et lesdits connecteurs coaxiaux contigus sont connectés à des sources micro-ondes fonctionnant en synchronisation de phase.

Selon une autre possibilité, le dispositif coupleur/combineur micro-ondes comprend au moins une barre transversale proximale et une barre transversale distale parallèles et décalées l'une de l'autre selon l'axe principal d'un écartement EC = N.Lg/2 où N entier positif, et les au moins deux connecteurs coaxiaux comprennent au moins un connecteur coaxial proximal dont l'antenne conductrice est fixée sur la barre transversale proximale et au moins un connecteur coaxial distal dont l'antenne conductrice est fixée sur la barre transversale distale, et dans lequel le connecteur coaxial proximal et le connecteurs coaxial distal sont connectés à des sources micro-ondes fonctionnant :

- soit en synchronisation de phase si N pair, à plus ou moins dix degrés ;
- soit en déphasage de 180 degrés si N impair, à plus ou moins dix degrés.

Avantageusement, la fréquence est ajustable dans une bande de fréquences donnée autour de la fréquence $f_0$ de sorte que la longueur d'onde guidée dans le guide d'ondes est ajustable dans une bande de longueur d'onde donnée autour de la longueur d'onde guidée $\lambda$g, et dans lequel le générateur micro-ondes comprend en outre un module de pilotage des phases des sources micro-ondes pour ajuster individuellement les phases des sources micro-ondes en fonction de l'ajustement de la longueur d'onde dans la bande de longueur d'onde donnée.

Selon une caractéristique avantageuse, les sources micro-ondes sont des sources micro-ondes à état solide.

Selon une autre caractéristique avantageuse, la fréquence est :

- soit comprise dans une bande de fréquences de 2,450 GHz $\pm$ 50,0 MHz, et notamment la fréquence est ajustable dans une bande de fréquences de 2,450 GHz $\pm$ 50,0 MHz ;
- soit comprise dans une bande de fréquences de 5,800 GHz $\pm$ 75,0 MHz, et notamment la fréquence est ajustable dans une bande de fréquences de 5,800 GHz $\pm$ 75,0 MHz ;
- soit comprise dans une bande de fréquences de 433,92 MHz $\pm$ 0,87, et notamment la fréquence est ajustable dans une bande de fréquences de 433,92 MHz $\pm$ 0,87 ;
- soit comprise dans une bande de fréquences de 896 MHz $\pm$ 10 MHz, et notamment la fréquence est ajustable dans une bande de fréquences de 896 MHz $\pm$ 10 MHz;
- soit comprise dans une bande de fréquences de 915 MHz $\pm$ 13 MHz, et notamment la fréquence est ajustable dans une bande de fréquences de 915 MHz $\pm$ 13 MHz.

D'autres caractéristiques et avantages de la présente invention apparaîtront à la lecture de la description détaillée ci-après, d'un exemple de mise en oeuvre non limitatif, faite en référence aux figures annexées dans lesquelles :

- les figures 1 et 2 sont des vues schématiques en perspective d'un dispositif coupleur/combineur micro-ondes conforme à l'invention ;
- la figure 3 est une vue schématique du dispositif coupleur/combineur micro-ondes sans le flasque annulaire d'accouplement et avec une représentation en transparence de l'intérieur du manchon du guide d'ondes ;
- les figures 4 et 5 sont des schémas d'un premier exemple et d'un deuxième exemple de dispositif coupleur/combineur micro-ondes ;
- la figure 6 est une vue schématique zoomée sur une interface connecteur coaxial/ âme centrale conductrice/antenne conductrice /barre transversale, dans les exemples des figures 4 et 5 ;
- la figure 7 est un schéma d'un exemple d'un troisième exemple de dispositif coupleur/combineur micro-ondes ;
- la figure 8 est une vue schématique zoomée sur une interface connecteur coaxial/ âme centrale conductrice/antenne conductrice /barre transversale, dans le troisième exemple de la figure 7 ;

- la figure 9 est un schéma d'un exemple d'un quatrième exemple de dispositif coupleur/combineur micro-ondes ;
- les figures 10 et 11 sont des vues schématiques en perspective d'un ensemble micro-ondes comprenant un dispositif coupleur/combineur micro-ondes des figures 1 et 2 sur lequel sont accouplés des sources micro-ondes à état solide ; et
- les figures 12 et 13 sont des vues schématiques en perspective, respectivement de face et sans carter et de dos et avec carter, d'un générateur micro-ondes intégrant l'ensemble micro-ondes des figures 10 et 11.

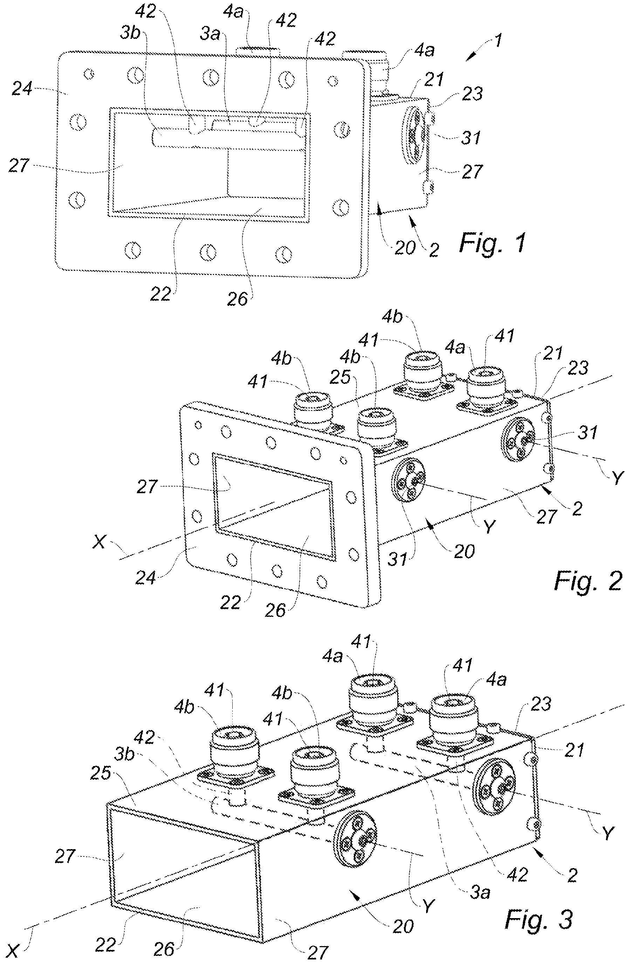

En référence aux figures 1 à 9, un dispositif coupleur/combineur micro-ondes 1 selon l'invention comprend un guide d'ondes 2 muni d'un manchon 20 conducteur s'étendant longitudinalement selon un axe principal X et présentant deux extrémités 21, 22 opposées comprenant :

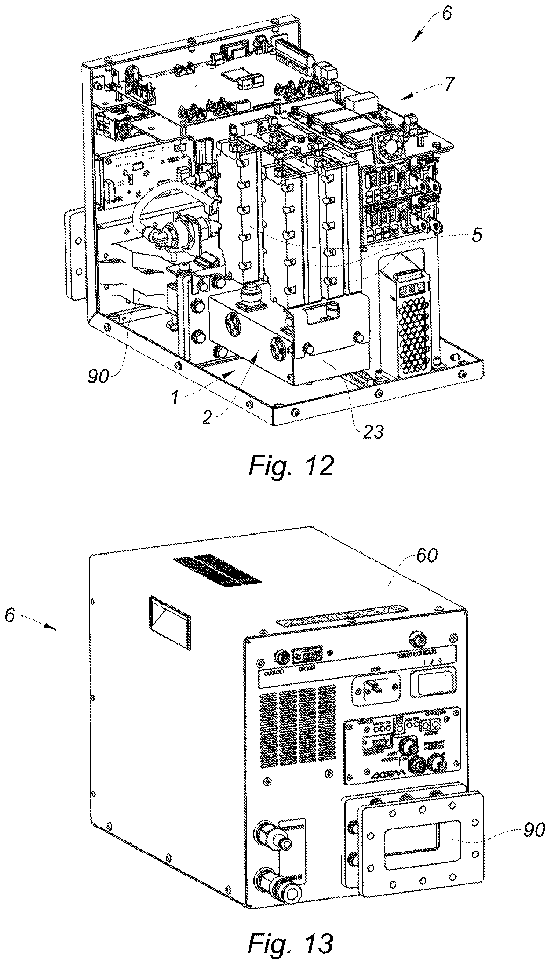

- une première extrémité 21 munie d'un élément formant court-circuit 23, par exemple sous la forme d'une plaque ou paroi de court-circuit fermant la première extrémité 21 ; et
- une seconde extrémité 22 ouverte, munie par exemple d'un flasque annulaire d'accouplement 24 prévue pour accoupler le manchon 20 du guide d'ondes 2 à un guide de sortie 90 (visible sur les figures 12 et 13).

Le manchon 20 est ici de section rectangulaire, de sorte que le manchon 20 présente une face supérieure 25 et une face inférieure 26 qui sont parallèles et en vis-à-vis, ainsi que deux faces latérales 27 également parallèles et en vis-à-vis. Bien entendu, l'invention n'est pas limitée à cette géométrie rectangulaire du manchon 20.

Le guide d'ondes 2 comprend également au moins une barre transversale 3a, 3b, 3c, 3d s'étendant à l'intérieur du manchon 20 selon un axe transversal Y orthogonal à l'axe principal X.

Dans les exemples illustrés sur les figures 1 à 5 et 7, le guide d'ondes 2 comprend deux barres transversales, avec plus spécifiquement une barre transversale proximale 3a et une barre transversale distale 3b. La barre transversale proximale 3a et la barre transversale distale 3b sont parallèles et elles sont décalées l'une de l'autre selon l'axe principal X, avec la barre transversale proximale 3a située plus proche de l'élément formant court-circuit 23 que la barre transversale distale 3b.

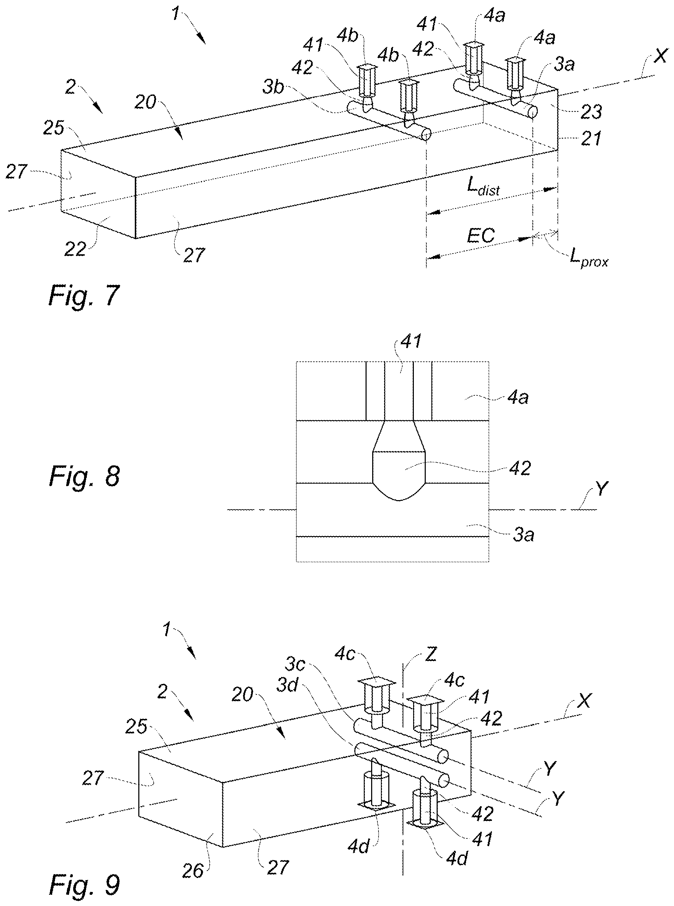

Dans l'exemple illustré sur la figure 9, le guide d'ondes 2 comprend deux barres transversales, avec plus spécifiquement une barre transversale supérieure 3c et une barre transversale inférieure 3d parallèles et décalées l'une de l'autre selon un axe secondaire Z à la fois orthogonal à l'axe principal X et aux axes transversaux Y de ces barres transversales 3c, 3d de sorte que la barre transversale supérieure 3c et la barre transversale inférieure 3d s'étendent dans un plan commun orthogonal à l'axe principal X. La barre transversale supérieure 3c est située plus proche de la face supérieure 25 que la barre transversale inférieure 3d. Plus précisément, l'axe secondaire Z est orthogonal à la face supérieure 25 et à la face inférieure 26.

De manière générale, la ou chaque barre transversale 3a, 3b, 3c, 3d s'étend entre les deux faces latérales 27, parallèlement à la face supérieure 25 et à la face inférieure 26, à une distance donnée de la face supérieure 25 (ou de la face inférieure 26). A ce titre, la ou chaque barre transversale 3a, 3b, 3c, 3d présente deux extrémités opposées fixées chacune sur une face latérale 27, notamment au moyen d'une vis 31 ou d'un soudage.

De plus, la ou chaque barre transversale 3a, 3b, 3c, 3d est réalisée dans un matériau électriquement conducteur ayant une conductivité thermique d'au moins 100 W/(m.K), et est notamment réalisée en cuivre, laiton, aluminium, or ou argent, à des fins de bonne dissipation thermique.

La ou chaque barre transversale 3a, 3b, 3c, 3d peut être de section circulaire avec un diamètre donnée, bien que cette forme ne soit pas limitative.

Il est en outre envisageable que la ou chaque barre transversale 3a, 3b, 3c, 3d soit creuse afin notamment qu'un liquide de refroidissement puisse être mis en circulation à l'intérieur de la barre transversale 3a, 3b, 3c, 3d creuse, toujours à des fins de bonne dissipation thermique.

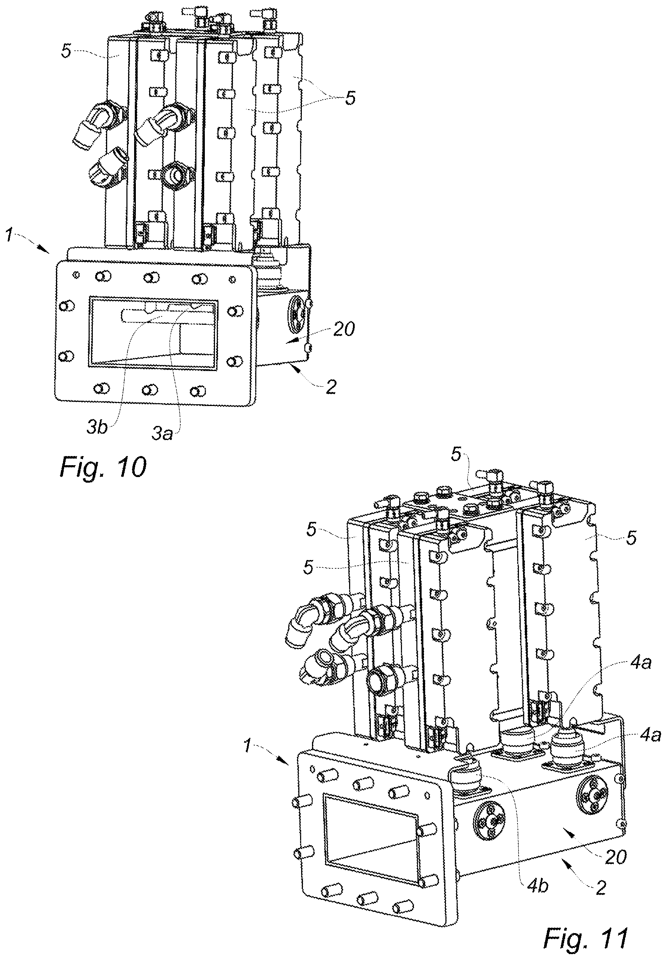

Le dispositif coupleur/combineur micro-ondes 1 selon l'invention comprend également au moins deux connecteurs coaxiaux 4a, 4b, 4c, 4d prévus pour être respectivement connectés à des sources micro-ondes 5, et en particulier des sources micro-ondes à état solide 5 (visibles sur les figures 10 à 13).

De manière générale, chaque connecteur coaxial 4a, 4b, 4c, 4d est monté extérieurement sur le manchon 20, et en particulier sur la face supérieure 25 ou la face inférieure 26, et il présente un moyen d'accouplement pour accoupler soit directement la source micro-ondes 5, soit un câble coaxial qui assure la liaison entre la source micro-ondes 5 et le connecteur coaxial 4a, 4b, 4c, 4d. Un accouplement direct est favorisé pour limiter les pertes.

Le moyen d'accouplement peut être un moyen d'accouplement mâle ou femelle, il peut aussi être un moyen d'accouplement par vissage ou à baïonnette ou à encliquetage, ou via un câble coaxial.

Chaque connecteur coaxial 4a, 4b, 4c, 4d est dont fixé sur le manchon 20, notamment par vissage ou soudage, et il présente une âme centrale conductrice 41 reliée à et prolongée par une antenne conductrice 42 s'étendant à l'intérieur du manchon 20 et se terminant par une extrémité fixée, notamment par soudage ou vissage, sur une barre transversale 3a, 3b, 3c, 3d.

Pour chaque connecteur coaxial 4a, 4b, 4c, 4d, l'âme centrale conductrice 41 et l'antenne conductrice 42 sont alignées (ou coaxiales) et s'étendent selon une direction orthogonale à l'axe transversal Y de la barre transversale 3a, 3b, 3c, 3d, de sorte que l'antenne conductrice 42 et la barre transversale 3a, 3b, 3c, 3d sont perpendiculaires. Plus précisément, l'âme centrale conductrice 41 et l'antenne conductrice 42 s'étendent selon une direction parallèle à l'axe secondaire Z précité, donc orthogonale à la face supérieure 25 et à la face inférieure 26.

Dans les exemples illustrés sur les figures, le dispositif coupleur/combineur micro-ondes 1 comprend deux connecteurs coaxiaux 4a, 4b, 4c, 4d pour une barre transversale 3a, 3b, 3c, 3d. Ainsi, pour la ou chaque barre transversale 3a, 3b, 3c, 3d est accouplé une paire (ou un couple) de connecteurs coaxiaux 4a, 4b, 4c, 4d, c'est-à-dire deux connecteurs coaxiaux contigus dont les antennes conductrices 42 sont fixées sur une même barre transversale 3a, 3b, 3c, 3d, où ces deux connecteurs coaxiaux contigus 4a, 4b, 4c, 4d sont disposés côte à côte selon une direction parallèle à l'axe transversal Y de la barre transversale 3a, 3b, 3c, 3d.

Plus précisément, deux connecteurs coaxiaux contigus 4a, 4b, 4c, 4d sont disposés symétriquement de part et d'autre d'un plan de symétrie du manchon 2 incluant l'axe principal X. Ainsi, l'un des deux connecteurs coaxiaux contigus 4a, 4b, 4c, 4d est situé à une distance donnée de l'une des deux faces latérales 27, et l'autre des deux connecteurs coaxiaux contigus 4a, 4b, 4c, 4d est situé à la même distance donnée de l'autre des deux faces latérales 27.

Dans les exemples illustrés sur les figures 1 à 5 et 7, le guide d'ondes 2 comprend :

- deux connecteurs coaxiaux contigus proximaux 4a dont les antennes conductrices 42 sont fixées sur la barre transversale proximale 3a ; et
- deux connecteurs coaxiaux contigus distaux 4b dont les antennes conductrices 42 sont fixées sur la barre transversale distale 3b.

Les connecteurs coaxiaux contigus proximaux 4a et les connecteurs coaxiaux contigus distaux 4b sont alignés et décalés deux à deux selon une direction parallèle à l'axe principal X.

Dans l'exemple illustré sur la figure 9, le guide d'ondes 2 comprend :

- deux connecteurs coaxiaux contigus supérieurs 4c montés sur la face supérieure 25 du manchon 20 et dont les antennes conductrices 42 sont fixées sur la barre transversale supérieure 3c ; et
- deux connecteurs coaxiaux contigus inférieurs 4d montés sur la face inférieure 26 du manchon 20 et dont les antennes conductrices 42 sont fixées sur la barre transversale inférieure 3d.

Les antennes conductrices des connecteurs coaxiaux contigus supérieurs 4c et les antennes conductrices des connecteurs coaxiaux contigus inférieurs 4d sont alignés deux à deux. Par ailleurs, ces connecteurs coaxiaux contigus 4c, 4d s'étendent dans le plan commun de la barre transversale supérieure 3c et de la barre transversale inférieure 3d.

En outre, il est à noter que les sources micro-ondes à état solide 5 émettent des micro-ondes à une même fréquence $f_0$ et une même longueur d'onde $\lambda_0$ données, avec une bande de fréquences qui est par exemple de 2,450 GHz $\pm$ 50,0 MHz, où la fréquence est plus particulièrement ajustable dans cette bande de fréquences de 2,450 GHz $\pm$ 50,0 MHz avec $f_0$ la fréquence centrale de la bande.

Bien entendu, les autres bandes de fréquences micro-ondes d'usage industriel, scientifique et médical (ISM) attribuées par l'Union internationale des télécommunications (UIT) sont aussi envisageables.

De manière générale, la ou chaque barre transversale 3a, 3b, 3c, 3d est disposée à une longueur L donnée de l'élément formant court-circuit 23, selon l'axe principal, avec :

$$Lc + k.Lg/2,$$

où

k est un entier nul ou positif ;
Lc = $p.\lambda g/4$ ;
Lg = $\lambda g \pm$ 10 % ;
$\lambda g$ correspond à la longueur d'onde guidée des micro-ondes à l'intérieur du guide d'ondes, qui dépend des dimensions du guide d'ondes ;
p est un coefficient de correction inférieur à 1.

Dans les exemples des figures 1 à 7, la barre transversale proximale 3a et la barre transversale distale 3b sont disposées à des longueurs respectives Lprox et Ldist données de l'élément formant court-circuit 23, selon l'axe principal

X, avec :

$$Lprox = Lc + kprox.Lg/2,$$

où kprox entier nul ou positif

$$Ldist = Lc + kdist.Lg/2,$$

où kdist entier positif supérieur à kprox.

Ainsi, la barre transversale proximale 3a et la barre transversale distale 3b sont décalées l'une de l'autre selon l'axe principal d'un écartement EC, tel que :

$$EC = Ldist - Lprox = (kdist - kprox). Lg/2 = N. Lg/2$$

où N entier positif.

Dans les exemples des figures 1 à 4 et 7, qui correspond à une configuration particulièrement compactée, on a kprox = 0 et kdist = 1, autrement dit : Lprox = Lc, Ldist = Le + Lg/2 et EC = Lg/2.

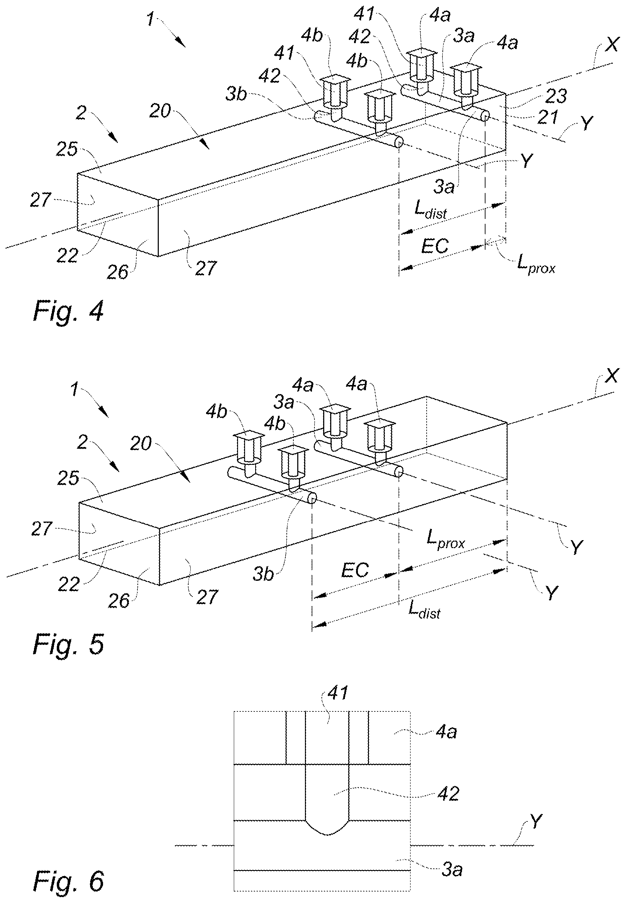

Dans l'exemple de la figure 5, qui correspond à une configuration moins compactée mais qui pourrait avoir parfois un avantage sur la bande passante des micro-ondes combinées, on a kprox = 1 et kdist = 2, autrement dit : Lprox = Le + Lg/2, Ldist = Le + Lg et EC = Lc/2

Dans l'exemple de la figure 9, qui correspond aussi à une configuration particulièrement compactée, la barre transversale supérieure 3c et la barre transversale inférieure 3d sont toutes les deux situées à la même longueur L donnée de l'élément formant court-circuit 23, selon l'axe principal, avec : L = Lc.

En outre, pour chaque connecteur coaxial 4a, 4b, 4c, 4d, l'extrémité de l'antenne conductrice 42 présente un diamètre inférieur, supérieur ou égal au diamètre de la barre transversale 3a, 3b, 3c, 3d sur laquelle elle est fixée.

Dans une réalisation particulière, donnée à titre d'exemple non limitatif, pour chaque connecteur coaxial 4a, 4b, 4c, 4d, l'extrémité de l'antenne conductrice 42 présente un diamètre équivalent à 15% près au diamètre de la barre transversale 3a, 3b, 3c, 3d sur laquelle elle est fixée, et ainsi trois cas de figure se présentent :

- premier cas de figure illustré sur la figure 5, si l'âme centrale conductrice 41 présente un diamètre équivalent à 15% près au diamètre de la barre transversale 3a, 3b, 3c, 3d, alors l'âme centrale conductrice 41 et l'antenne conductrice 42 présentent le même diamètre constant ;
- deuxième cas de figure illustré sur la figure 8, si l'âme centrale conductrice 41 présente un diamètre inférieur au diamètre de la barre transversale 3a, 3b, 3c, 3d, alors l'antenne conductrice 42 présente un diamètre croissant progressivement à partir de l'âme centrale conductrice 41 jusqu'à atteindre un diamètre équivalent à 15% près au diamètre de la barre transversale 3a, 3b, 3c, 3d ;
- troisième cas de figure non illustré, si l'âme centrale conductrice 41 présente un diamètre supérieur au diamètre de la barre transversale 3a, 3b, 3c, 3d, alors l'antenne conductrice 42 présente un diamètre décroissant progressivement à partir de l'âme centrale conductrice 41 jusqu'à atteindre un diamètre équivalent à 15% près au diamètre de la barre transversale 3a, 3b, 3c, 3d.

En référence aux figures 12 et 13, un générateur micro-ondes 6 selon l'invention comprend, à l'intérieur d'un carter 60 :

- un dispositif coupleur/combineur micro-ondes 1 ; et
- plusieurs sources micro-ondes à état solide 5 connectées respectivement aux connecteurs coaxiaux 4a, 4b, 4c, 4d du dispositif coupleur/combineur micro-ondes 1 ;
- un module de pilotage 7 qui pilote les phases des sources micro-ondes à état solide 5 pour ajuster individuellement les phases des sources micro-ondes à état solide 5.

Considérant deux connecteurs coaxiaux contigus 4a, ou 4b, ou 4c, ou 4d, dont les antennes conductrices 42 sont fixées sur une même barre transversale 3a, ou 3b, ou 3c, ou 3d, ces deux connecteurs coaxiaux contigus sont connectés à des sources micro-ondes à état solide 5 fonctionnant en synchronisation de phase, à plus ou moins dix degrés, cette synchronisation des phases de ces deux sources micro-ondes à état solide 5 étant pilotée par le module de pilotage 7.

Considérant, d'une part, deux connecteurs coaxiaux contigus proximaux 4a dont les antennes conductrices 42 sont fixées sur la barre transversale proximale 3a et qui sont accouplés à des sources micro-ondes à état solide 5 dites sources proximales et, d'autre part, deux connecteurs coaxiaux contigus distaux 4b dont les antennes conductrices 42 sont fixées sur la barre transversale distale 3b et qui sont accouplés à des sources micro-ondes à état solide 5 dites sources distales, et considérant que cette barre transversale proximale 3a et cette barre transversale distale 3b sont décalées l'une de l'autre selon l'axe principal X d'un écartement EC = N.Lg/2 où N entier positif, alors :

- si N pair, alors les sources proximales sont en synchronisation de phase avec les sources distales, à plus ou moins dix degrés ; et
- si N impair, alors les sources proximales sont en en déphasage de 180 degrés avec les sources distales, à plus ou moins dix degrés

Dans les exemples des figures 1 à 5 et 7, EC = Lg/2, autrement dit N=1, de sorte que les sources proximales sont en en déphasage de 180 degrés avec les sources distales, à plus ou moins dix degrés.

Ainsi, le module de pilotage 7 met en oeuvre une carte de gestion des phases, préférablement automatique, afin de synchroniser ensemble les sources micro-ondes à état solide 5 associées à une même barre transversale 3a, ou 3b, ou 3c, ou 3d, et déphaser les autres par rapport aux premiers de 180° (si écartement EC= Lg/2).

Par ailleurs, comme décrit précédemment, la fréquence est ajustable dans une bande de fréquences donnée autour de la fréquence $f_0$ de sorte que la longueur d'onde guidée est également ajustable dans une bande de longueur d'onde donnée autour de la longueur d'onde $\lambda_g$.

Ainsi, le module de pilotage 7 des phases des sources micro-ondes à état solide 5 pilotera individuellement les phases des sources micro-ondes à état solide 5 en fonction de cet ajustement de la longueur d'onde guidée dans la bande de longueur d'onde donnée, pour optimiser la transmission de la puissance.

Ce module de pilotage 7 va aussi permettre une gestion individuelle des phases de chaque source micro-ondes à état solide 5 pour prendre en considération d'éventuels déphasages qui peuvent apparaître à cause des tolérances sur les dimensions, des tolérances de chaque source micro-ondes à état solide 5, entre les connecteurs coaxiaux 4a, 4b, 4c, 4d eux-mêmes, etc. Cette gestion des phases peut aussi être gérée automatiquement en fonction de la fréquence des micro-ondes émises.

## Revendications

1. Dispositif coupleur/combineur micro-ondes (1) pour un couplage et une combinaison d'au moins deux sources micro-ondes (5), comprenant un guide d'ondes (2) muni de :

    - un manchon (20) s'étendant longitudinalement selon un axe principal (X) et présentant deux extrémités opposées comprenant une première extrémité (21) munie d'un élément formant court-circuit (23) et une seconde extrémité (22) ouverte ; et
    - au moins une barre transversale (3a; 3b; 3c; 3d) s'étendant à l'intérieur du manchon (20) selon un axe transversal (Y) orthogonal à l'axe principal (X) ; ledit dispositif coupleur/combineur micro-ondes (1) comprenant en outre au moins deux connecteurs coaxiaux (4a; 4b; 4c; 4d) prévus pour être respectivement connectés à des sources micro-ondes (5),
    dans lequel chaque connecteur coaxial (4a; 4b; 4c; 4d) est monté extérieurement sur le manchon (20) et présente une âme centrale conductrice (41) reliée à et prolongée par une antenne conductrice (42) s'étendant à l'intérieur du manchon (20) et se terminant par une extrémité, laquelle extrémité de l'antenne conductrice (42) étant fixée sur une barre transversale (3a; 3b; 3c; 3d), où ladite âme centrale conductrice (41) et ladite antenne conductrice (42) sont alignées et s'étendent selon une direction orthogonale à l'axe transversal (Y) et à l'axe principal (X) ;
    et dans lequel les au moins deux connecteurs coaxiaux comprennent deux connecteurs coaxiaux contigus (4a; 4b; 4c; 4d) dont les antennes conductrices (42) sont fixées sur une même barre transversale (3a; 3b; 3c; 3d), lesdits connecteurs coaxiaux contigus (4a; 4b; 4c; 4d) étant disposés côte à côte selon une direction parallèle à l'axe transversal (Y) de la barre transversale (3a; 3b; 3c; 3d).

2. Dispositif coupleur/combineur micro-ondes (1) selon la revendication 1, dans lequel le guide d'ondes (2) comprend au moins une barre transversale proximale (3a) et une barre transversale distale (3b) parallèles et décalées l'une de l'autre selon l'axe principal (X), et les au moins deux connecteurs coaxiaux comprennent au moins un connecteur coaxial proximal (4a) dont l'antenne conductrice (42) est fixée sur la barre transversale proximale (3a) et au moins un connecteur coaxial distal (4b) dont l'antenne conductrice (42) est fixée sur la barre transversale distale (3b).

3. Dispositif coupleur/combineur micro-ondes (1) selon la revendication 1 ou 2, dans lequel le guide d'ondes (2) comprend au moins une barre transversale supérieure (3c) et une barre transversale inférieure (3d) parallèles et décalées l'une de l'autre selon un axe secondaire (Z) à la fois orthogonal à l'axe principal (X) et aux axes transversaux (Y) desdites barres transversales (3c, 3d) de sorte que la barre transversale supérieure (3c) et la barre transversale inférieure (3d) s'étendent dans un plan commun orthogonal à l'axe principal (X), et les au moins deux connecteurs coaxiaux comprennent au moins un connecteur coaxial supérieur (4c) monté sur une face supérieure (25) du manchon (20) et dont l'antenne conductrice (42) est fixée sur la barre transversale supérieure (3c) et au moins un connecteur coaxial inférieur (4d) monté sur une face inférieure (26) du manchon (20) et dont l'antenne conductrice (42) est fixée sur la barre transversale inférieure (3d), et dans lequel le connecteur coaxial inférieur (4d) et le connecteur coaxial supérieur (4c) s'étendent dans le plan commun.

4. Dispositif coupleur/combineur micro-ondes (1) selon la revendication précédente, dans lequel l'antenne conductrice (42) du connecteur coaxial inférieur (4d) et l'antenne conductrice (42) du connecteur coaxial supérieur (4c) sont alignées.

5. Dispositif coupleur/combineur micro-ondes (1) selon l'une quelconque des revendications précédentes, dans lequel la au moins une barre transversale (3a; 3b; 3c; 3d) est réalisée dans un matériau ayant une conductivité thermique d'au moins 100 W/(m.K), et est par exemple réalisée dans un matériau à base de l'un au moins des métaux suivants : cuivre, laiton, aluminium, or et argent.

6. Dispositif coupleur/combineur micro-ondes (1) selon l'une quelconque des revendications précédentes, dans lequel la au moins une barre transversale (3a; 3b; 3c; 3d) est creuse.

7. Dispositif coupleur/combineur micro-ondes (1) selon la revendication précédente, dans lequel un liquide de refroidissement est mis en circulation à l'intérieur de la au moins une barre transversale (3a; 3b; 3c; 3d) creuse.

8. Dispositif coupleur/combineur micro-ondes (1) selon l'une quelconque des revendications précédentes, dans lequel, en considérant des sources micro-ondes (5) émettant des micro-ondes à une même fréquence $f_0$ et une même longueur d'onde $\lambda_0$ données, la au moins une barre transversale (3a; 3b; 3c; 3d) est disposée à une longueur L donnée de l'élément formant court-circuit (23), selon l'axe principal (X), avec :

$$L = Lc + k.Lg/2,$$

où

k est un entier nul ou positif ;
Lc = p.$\lambda$g/4;
Lg = $\lambda$g $\pm$ 10 %;
$\lambda$g correspond à la longueur d'onde guidée des micro-ondes à l'intérieur du guide d'ondes (2), qui dépend des dimensions du guide d'ondes (2) ;
p est un coefficient de correction inférieur à 1.

9. Dispositif coupleur/combineur micro-ondes (1) selon les revendications 2 et 8, dans lequel la barre transversale proximale (3a) et la barre transversale distale (3b) sont disposées à des longueurs respectives Lprox et Ldist données de l'élément formant court-circuit (23), selon l'axe principal (X), avec :

$$Lprox = Lc + kprox.Lg/2,$$

où kprox entier nul ou positif

$$Ldist = Lc + kdist.Lg/2,$$

où kdist entier positif supérieur à kprox ; de sorte que la barre transversale proximale (3a) et la barre transversale distale (3b) sont décalées l'une de l'autre selon l'axe principal (X) d'un écartement EC tel que :

$$EC = Ldist - Lprox = (kdist - kprox). \; Lg/2 = N. \; Lg/2$$

où N entier positif.

10. Dispositif coupleur/combineur micro-ondes (1) selon l'une quelconque des revendications précédentes, dans lequel, pour chaque connecteur coaxial (4a; 4b; 4c; 4d), l'extrémité de l'antenne conductrice (42) présente un diamètre équivalent à 15% près à un diamètre de la barre transversale (3a; 3b; 3c; 3d) sur laquelle elle est fixée.

11. Dispositif coupleur/combineur micro-ondes (1) selon la revendication précédente, dans lequel, pour chaque connecteur coaxial (4a; 4b; 4c; 4d), l'âme centrale conductrice (41) présente un diamètre inférieur, ou inversement supérieur, au diamètre de la barre transversale (3a; 3b; 3c; 3d) correspondante, et l'antenne conductrice (42) présente un diamètre croissant, ou inversement décroissant, progressivement à partir de l'âme centrale conductrice (41) jusqu'à atteindre un diamètre équivalent à 15% près au diamètre de la barre transversale (3a; 3b; 3c; 3d).

12. Générateur micro-ondes comprenant :

- au moins deux sources micro-ondes (5) émettant des micro-ondes à une même fréquence $f_0$ et une même longueur d'onde $\lambda_0$ données, comme par exemple des sources micro-ondes (5) à état solide ; et
- un dispositif coupleur/combineur micro-ondes (1) conforme à l'une quelconque des revendications précédentes ;

et dans lequel les sources micro-ondes (5) sont connectées respectivement aux connecteurs coaxiaux (4a; 4b; 4c; 4d) du dispositif coupleur/combineur micro-ondes (1).

13. Générateur micro-ondes selon la revendication 12, dans lequel le dispositif coupleur/combineur micro-ondes (1) comprend deux connecteurs coaxiaux contigus (4a; 4b; 4c; 4d) dont les antennes conductrices (42) sont fixées sur une même barre transversale (3a; 3b; 3c; 3d), lesdits connecteurs coaxiaux contigus (4a; 4b; 4c; 4d) étant disposés côte à côte selon l'axe transversal (Y) de la barre transversale (3a; 3b; 3c; 3d), et lesdits connecteurs coaxiaux contigus (4a; 4b; 4c; 4d) sont connectés à des sources micro-ondes (5) fonctionnant en synchronisation de phase.

14. Générateur micro-ondes selon l'une quelconque des revendications 12 et 13, dans lequel le dispositif coupleur/combineur micro-ondes (1) comprend au moins une barre transversale proximale (3a) et une barre transversale distale (3b) parallèles et décalées l'une de l'autre selon l'axe principal (X) d'un écartement EC = N.Lg/2 où N entier positif, et les au moins deux connecteurs coaxiaux (4a; 4b; 4c; 4d) comprennent au moins un connecteur coaxial proximal (4a) dont l'antenne conductrice (42) est fixée sur la barre transversale proximale (3a) et au moins un connecteur coaxial distal (4b) dont l'antenne conductrice (42) est fixée sur la barre transversale distale (3b), et dans lequel le connecteur coaxial proximal (4a) et le connecteurs coaxial distal (4b) sont connectés à des sources micro-ondes (5) fonctionnant :

- soit en synchronisation de phase si N pair, à plus ou moins dix degrés ;
- soit en déphasage de 180 degrés si N impair, à plus ou moins dix degrés.

15. Générateur micro-ondes selon l'une quelconque des revendications 12 à 14, dans lequel la fréquence est ajustable dans une bande de fréquences donnée autour de la fréquence $f_0$ de sorte que la longueur d'onde guidée dans le guide d'ondes est ajustable dans une bande de longueur d'onde donnée autour de la longueur d'onde $\lambda_g$, et dans lequel le générateur micro-ondes comprend en outre un module de pilotage des phases des sources micro-ondes (5) pour ajuster individuellement les phases des sources micro-ondes (5) en fonction de l'ajustement de la longueur d'onde dans la bande de longueur d'onde donnée.

**Patentansprüche**

1. Mikrowellenkoppler-/Kombinatorvorrichtung (1), zum Koppeln und Kombinieren von mindestens zwei Mikrowellenquellen (5), einen Wellenleiter (2) umfassend, der ausgestattet ist mit:

- einer Buchse (20), die sich in Längsrichtung entlang einer Hauptachse (X) erstreckt und zwei gegenüberliegende Enden aufweist, ein erstes Ende (21) umfassend, das mit einem Element ausgestattet ist, das einen Kurzschluss (23) bildet, und ein zweites offenes Ende (22); und
- mindestens einem Querstab (3a; 3b; 3c; 3d), der sich innerhalb der Buchse (20) entlang einer Querachse (Y) orthogonal zur Hauptachse (X) erstreckt;
wobei die Mikrowellenkoppler-/Kombinatorvorrichtung (1) ferner mindestens zwei Koaxialstecker (4a; 4b; 4c; 4d) umfasst, die vorgesehen sind, um jeweils mit Mikrowellenquellen (5) verbunden zu sein,
wobei jeder Koaxialstecker (4a; 4b; 4c; 4d) außen an der Buchse (20) angebracht ist und einen leitenden zentralen Kern (41) aufweist, der mit einer leitenden Antenne (42) verbunden und durch diese verlängert ist, die sich innerhalb der Buchse (20) erstreckt und mit einem Ende endet, wobei das Ende der leitenden Antenne (42) an einem Querstab (3a; 3b; 3c; 3d) befestigt ist, wobei der leitende zentrale Kern (41) und die leitende Antenne (42) ausgerichtet sind und sich entlang einer Richtung erstrecken, die orthogonal zur Querachse (Y) und zur Hauptachse (X) ist;
und wobei die mindestens zwei Koaxialstecker zwei zusammenhängende Koaxialstecker (4a; 4b; 4c; 4d) umfassen, deren leitende Antennen (42) an demselben Querstab (3a; 3b; 3c; 3d) befestigt sind, wobei die zusammenhängenden Koaxialstecker (4a; 4b; 4c; 4d) entlang einer Richtung parallel zur Querachse (Y) des Querstabes (3a; 3b; 3c; 3d) nebeneinander angeordnet sind.

2. Mikrowellenkoppler-ZKombinatorvorrichtung (1) nach Anspruch 1, wobei der Wellenleiter (2) mindestens einen proximalen Querstab (3a) und einen distalen Querstab (3b) umfasst, die parallel sind und voneinander versetzt entlang der Hauptachse (X), und die mindestens zwei Koaxialstecker mindestens einen proximalen Koaxialstecker (4a) umfassen, dessen leitende Antenne (42) am proximalen Querstab (3a) befestigt ist, und mindestens einen distalen Koaxialstecker (4b), dessen leitende Antenne (42) am distalen Querstab (3b) befestigt ist.

3. Mikrowellenkoppler-/Kombinatorvorrichtung (1) nach Anspruch 1 oder 2, wobei der Wellenleiter (2) mindestens einen oberen Querstab (3c) und einen unteren Querstab (3d) umfasst, die parallel sind und voneinander versetzt entlang einer sekundären Achse (Z), die sowohl orthogonal zur Hauptachse (X) als auch zu den Querachsen (Y) der Querstäbe (3c, 3d) ist, so dass sich der obere Querstab (3c) und der untere Querstab (3d) in einer gemeinsamen Ebene erstrecken, die orthogonal zur Hauptachse (X) ist, und die mindestens zwei Koaxialstecker mindestens einen oberen Koaxialstecker (4c) umfassen, der auf einer oberen Fläche (25) der Buchse (20) angebracht ist, und dessen leitende Antenne (42) am oberen Querstab (3c) befestigt ist, und mindestens einen unteren Koaxialstecker (4d), der an einer unteren Fläche (26) der Buchse (20) angebracht ist, und dessen leitende Antenne (42) am unteren Querstab (3d) befestigt ist, und wobei sich der untere Koaxialstecker (4d) und der obere Koaxialstecker (4c) in der gemeinsamen Ebene erstrecken.

4. Mikrowellenkoppler-/Kombinatorvorrichtung (1) nach dem vorhergehenden Anspruch, wobei die leitende Antenne (42) des unteren Koaxialsteckers (4d) und die leitende Antenne (42) des oberen Koaxialsteckers (4c) ausgerichtet sind.

5. Mikrowellenkoppler-/Kombinatorvorrichtung (1) nach einem der vorhergehenden Ansprüche, wobei der mindestens eine Querstab (3a; 3b; 3c; 3d) aus einem Material mit einer Wärmeleitfähigkeit von mindestens 100 W/(m.K) hergestellt ist und beispielsweise hergestellt ist aus einem Material, das auf mindestens einem der folgenden Metalle basiert: Kupfer, Messing, Aluminium, Gold und Silber.

6. Mikrowellenkoppler-/Kombinatorvorrichtung (1) nach einem der vorhergehenden Ansprüche, wobei der mindestens eine Querstab (3a; 3b; 3c; 3d) hohl ist.

7. Mikrowellenkoppler-/Kombinatorvorrichtung (1) nach dem vorhergehenden Anspruch, wobei eine Kühlflüssigkeit innerhalb des mindestens einen hohlen Querstabes (3a; 3b; 3c; 3d) in Zirkulation gebracht wird.

8. Mikrowellenkoppler-ZKombinatorvorrichtung (1) nach einem der vorhergehenden Ansprüche, wobei, unter Berücksichtigung, dass die Mikrowellenquellen (5) Mikrowellen mit derselben gegebenen Frequenz $f_0$ und derselben Wellenlänge $\lambda_0$ emittieren, der mindestens eine Querstab (3a; 3b; 3c; 3d) in einer gegebenen Länge L des Elements, das einen Kurzschluss (23) bildet, angeordnet ist, entlang der Hauptachse (X), mit:

$$L = Lc + K.Lg/2,$$

wobei

k eine Ganzzahl, null oder positiv, ist;

Lc = p.λg/4;

Lg = λg ± 10 %;

λg der geleiteten Wellenlänge der Mikrowellen innerhalb des Wellenleiters (2) entspricht, die von den Abmessungen des Wellenleiters (2) abhängt;

p ein Korrekturkoeffizient von weniger als 1 ist.

9. Mikrowellenkoppler-/Kombinatorvorrichtung (1) nach den Ansprüchen 2 und 8, wobei der proximale Querstab (3a) und der distale Querstab (3b) in jeweils gegebenen Längen Lprox und Ldist des Elements angeordnet sind, das einen Kurzschluss (23) bildet, entlang der Hauptachse (X), mit:

$$Lprox = Lc + kprox.Lg/2,$$

wobei kprox eine Ganzzahl, null oder positiv, ist;

$$Ldist = Lc + kdist.Lg/2,$$

wobei kdist eine positive Ganzzahl größer als kprox ist;

so dass der proximale Querstab (3a) und der distale Querstab (3b) voneinander um einen Abstand EC versetzt sind entlang der Hauptachse (X), wobei:

$$EC = Ldist - Lprox = (kdist - kprox). Lg/2 = N. Lg/2,$$

wobei N eine positive Ganzzahl ist.

10. Mikrowellenkoppler-/Kombinatorvorrichtung (1) nach einem der vorhergehenden Ansprüche, wobei, für jeden Koaxialstecker (4a; 4b; 4c; 4d), das Ende der leitenden Antenne (42) einen Durchmesser aufweist, der bis zu 15 % genau dem Durchmesser des Querstabes (3a; 3b; 3c; 3d) entspricht, an dem sie befestigt ist.

11. Mikrowellenkoppler-/Kombinatorvorrichtung (1) nach dem vorhergehenden Anspruch, wobei, für jeden Koaxialstecker (4a; 4b; 4c; 4d), der leitende zentrale Kern (41) einen Durchmesser aufweist, der kleiner oder invers größer ist als der Durchmesser des entsprechenden Querstabes (3a; 3b; 3c; 3d), und die leitende Antenne (42) einen zunehmenden, oder invers abnehmenden Durchmesser aufweist, progressiv ab dem leitenden zentralen Kern (41) bis zum Erreichen eines Durchmessers, der bis zu 15 % genau dem Durchmesser des Querstabes (3a; 3b; 3c; 3d) entspricht.

12. Mikrowellengenerator, umfassend:

- mindestens zwei Mikrowellenquellen (5), die Mikrowellen mit derselben gegebenen Frequenz $f_0$ und derselben Wellenlänge $\lambda_0$ emittieren, wie beispielsweise Mikrowellenquellen (5) im Festzustand; und
- eine Mikrowellenkoppler-ZKombinatorvorrichtung (1) nach einem der vorhergehenden Ansprüche;

und wobei die Mikrowellenquellen (5) jeweils mit den Koaxialsteckern (4a; 4b; 4c; 4d) der Mikrowellenkoppler-ZKombinatorvorrichtung (1) verbunden sind.

13. Mikrowellengenerator nach Anspruch 12, wobei die Mikrowellenkoppler-ZKombinatorvorrichtung (1) zwei zusammenhängende Koaxialstecker (4a; 4b; 4c; 4d) umfasst, deren leitende Antennen (42) an demselben Querstab (3a; 3b; 3c; 3d) befestigt sind, wobei die zusammenhängenden Koaxialstecker (4a; 4b; 4c; 4d) entlang der Querachse (Y) des Querstabes (3a; 3b; 3c; 3d) nebeneinander angeordnet sind, und wobei die zusammenhängenden Koaxialstecker (4a; 4b; 4c; 4d) mit Mikrowellenquellen (5) verbunden sind, die in Phasensynchronisation funktionieren.

14. Mikrowellengenerator nach einem der Ansprüche 12 und 13, wobei die Mikrowellenkoppler-/Kombinatorvorrichtung (1) mindestens einen proximalen Querstab (3a) und einen distalen Querstab (3b) umfasst, die parallel sind und voneinander um einen Abstand EC = N.Lg/2, wobei N eine positive Ganzzahl ist, versetzt entlang der Hauptachse (X), und wobei die mindestens zwei Koaxialstecker (4a; 4b; 4c; 4d) mindestens einen proximalen Koaxialstecker (4a) umfassen, dessen leitende Antenne (42) am proximalen Querstab (3a) befestigt ist, und mindestens einen distalen Koaxialstecker (4b), dessen leitende Antenne (42) am distalen Querstab (3b) befestigt ist, und wobei der proximale Koaxialstecker (4a) und der distale Koaxialstecker (4b) mit funktionierenden Mikrowellenquellen (5) verbunden sind:

- entweder in Phasensynchronisation, wenn N gerade ist, bei plus oder minus zehn Grad;
- oder in Phasenverschiebung um 180 Grad, wenn N ungerade ist, bei plus oder minus zehn Grad.

15. Mikrowellengenerator nach einem der Ansprüche 12 bis 14, wobei die Frequenz in einem gegebenen Frequenzband im Bereich der Frequenz $f_0$ einstellbar ist, so dass die im Wellenleiter geleitete Wellenlänge in einem gegebenen Wellenlängenband im Bereich der Wellenlänge $\lambda_g$ einstellbar ist, und wobei der Mikrowellengenerator ferner ein Phasensteuermodul der Mikrowellenquellen (5) umfasst zum individuellen Einstellen der Phasen der Mikrowellenquellen (5) in Abhängigkeit von der Einstellung der Wellenlänge im gegebenen Wellenlängenband.

## Claims

1. A microwave coupler/combiner device (1) for coupling and combining at least two microwave sources (5), comprising a waveguide (2) provided with:

   - a sleeve (20) extending longitudinally along a main axis (X) and having two opposite ends comprising a first end (21) provided with a short-circuit element (23) and an open second end (22); and
   - at least one transverse bar (3a; 3b; 3c; 3d) extending inside the sleeve (20) along a transverse axis (Y) orthogonal to the main axis (X);
   said microwave coupler/combiner device (1) further comprising at least two coaxial connectors (4a; 4b; 4c; 4d) provided to be respectively connected to microwave sources (5),
   wherein each coaxial connector (4a; 4b; 4c; 4d) is externally mounted on the sleeve (20) and has a central conductive core (41) connected to and extended by a conductive antenna (42) extending inside the sleeve (20) and ending by an end, which end of the conductive antenna (42) being fixed on a transverse bar (3a; 3b; 3c; 3d), wherein said central conductive core (41) and said conductive antenna (42) are aligned and extend in a direction orthogonal to the transverse axis (Y) and to the main axis (X);
   and wherein the at least two coaxial connectors comprise two contiguous coaxial connectors (4a; 4b; 4c; 4d) whose conductive antennas (42) are fixed on a same transverse bar (3a; 3b; 3c; 3d), said contiguous coaxial connectors (4a; 4b; 4c; 4d) being disposed side by side in a direction parallel to the transverse axis (Y) of the transverse bar (3a; 3b; 3c; 3d).

2. The microwave coupler/combiner device (1) according to claim 1, wherein the waveguide (2) comprises at least one proximal transverse bar (3a) and one distal transverse bar (3b) which are parallel and offset from each other along the main axis (X), and the at least two coaxial connectors comprise at least one proximal coaxial connector (4a) whose conductive antenna (42) is fixed on the proximal transverse bar (3a) and at least one distal coaxial connector (4b) whose conductive antenna (42) is fixed on the distal transverse bar (3b).

3. The microwave coupler/combiner device (1) according to claim 1 or 2, wherein the waveguide (2) comprises at least one upper transverse bar (3c) and one lower transverse bar (3d) which are parallel and offset from each other along a secondary axis (Z) both orthogonal to the main axis (X) and to the transverse axes (Y) of said transverse bars (3c, 3d) so that the upper transverse bar (3c) and the lower transverse bar (3d) extend in a common plane orthogonal to the main axis (X), and the at least two coaxial connectors comprise at least one upper coaxial connector (4c) mounted on an upper face (25) of the sleeve (20) and whose conductive antenna (42) is fixed on the upper transverse bar (3c) and at least one lower coaxial connector (4d) mounted on a lower face (26) of the sleeve (20) and whose conductive antenna (42) is fixed on the lower transverse bar (3d), and wherein the lower coaxial connector (4d) and the upper coaxial connector (4c) extend in the common plane.

4. The microwave coupler/combiner device (1) according to the preceding claim, wherein the conductive antenna (42) of the lower coaxial connector (4d) and the conductive antenna (42) of the upper coaxial connector (4c) are aligned.

5. The microwave coupler/combiner device (1) according to any one of the preceding claims, wherein the at least one transverse bar (3a; 3b; 3c; 3d) is made of a material having a thermal conductivity of at least 100 W/(m.k), and is for example made of a material based on at least one of the following metals: copper, brass, aluminium, gold and silver.

6. The microwave coupler/combiner device (1) according to any one of the preceding claims, wherein the at least one transverse bar (3a; 3b; 3c; 3d) is hollow.

7. The microwave coupler/combiner device (1) according to the preceding claim, wherein a cooling liquid is brought into circulation inside the at least one hollow transverse bar (3a; 3b; 3c; 3d).

8. The microwave coupler/combiner device (1) according to any one of the preceding claims, wherein, by considering microwave sources (5) emitting microwaves at a same given frequency $f_0$ and a same given wavelength $\lambda_0$, the at least one transverse bar (3a; 3b; 3c; 3d) is disposed at a given length L of the short-circuit element (23), along the main axis (X), with:

$$L = Lc + k.Lg/2,$$

wherein

k is a null or positive integer;
$Lc = p.\lambda g/4$;
$Lg = \lambda g \pm 10\ \%$;
$\lambda g$ corresponds to the guided wavelength of the microwaves inside the waveguide (2), which depends on the dimensions of the waveguide (2);
p is a correction coefficient less than 1.

9. The microwave coupler/combiner device (1) according to claims 2 and 8, wherein the proximal transverse bar (3a) and the distal transverse bar (3b) are disposed at respective given lengths Lprox and Ldist of the short-circuit element (23), along the main axis (X), with:

$$Lprox = Lc + kprox.Lg/2,$$

where kprox is a null or positive integer

$$Ldist = Lc + kdist.Lg/2,$$

where kdist is a positive integer greater than kprox; so that the proximal transverse bar (3a) and the distal transverse bar (3b) are offset from each other along the main axis (X) by a spacing EC such that:

$$EC = Ldist - Lprox = (kdist - kprox).Lg/2 = N.Lg/2$$

wherein N is a positive integer.

10. The microwave coupler/combiner device (1) according to any one of the preceding claims, wherein, for each coaxial connector (4a; 4b; 4c; 4d), the end of the conductive antenna (42) has a diameter which is equivalent within 15% to a diameter of the transverse bar (3a; 3b; 3c; 3d) on which it is fixed.

11. The microwave coupler/combiner device (1) according to the preceding claim, wherein , for each coaxial connector (4a; 4b; 4c; 4d), the central conductive core (41) has a diameter smaller, or conversely greater, than the diameter of the corresponding transverse bar (3a; 3b; 3c; 3d), and the conductive antenna (42) has a diameter increasing, or conversely decreasing, progressively from the central conductive core (41) until it reaches a diameter equivalent within 15% to the diameter of the transverse bar (3a; 3b; 3c; 3d).

12. A microwave generator comprising:

 - at least two microwave sources (5) emitting microwaves at a same given frequency $f_0$ and a same given

wavelength $\lambda_0$, such as microwave sources (5) at solid state; and
- a microwave coupler/combiner device (1) in accordance with any one of the preceding claims;

and wherein the microwave sources (5) are respectively connected to the coaxial connectors (4a; 4b; 4c; 4d) of the microwave coupler/combiner device (1).

13. The microwave generator according to claim 12, wherein the microwave coupler/combiner device (1) comprises two contiguous coaxial connectors (4a; 4b; 4c; 4d) whose conductive antennas (42) are fixed on a same transverse bar (3a; 3b; 3c; 3d), said contiguous coaxial connectors (4a; 4b; 4c; 4d) being disposed side by side along the transverse axis (Y) of the transverse bar (3a; 3b; 3c; 3d), and said contiguous coaxial connectors (4a; 4b; 4c; 4d) are connected to microwave sources (5) operating in phase synchronization.

14. The microwave generator according to any one of claims 12 and 13, wherein the microwave coupler/combiner device (1) comprises at least one proximal transverse bar (3a) and one distal transverse bar (3b) which are parallel and offset from each other along the main axis (X) by a spacing EC = N.Lg/2 wherein N is a positive integer, and the at least two coaxial connectors (4a; 4b; 4c; 4d) comprise at least one proximal coaxial connector (4a) whose conductive antenna (42) is fixed on the proximal transverse bar (3a) and at least one distal coaxial connector (4b) whose conductive antenna (42) is fixed on the distal transverse bar (3b),
and wherein the proximal coaxial connector (4a) and the distal coaxial connector (4b) are connected to microwave sources (5) operating:

- either in phase synchronization if N is even, plus or minus ten degrees;
- or in phase shift of 180 degrees if N is odd, plus or minus ten degrees.

15. The microwave generator according to any one of claims 12 to 14, wherein the frequency is adjustable in a given frequency band around the frequency $f_0$ so that the wavelength guided in the waveguide is adjustable in a given wavelength band around the wavelength $\lambda_g$,
and wherein the microwave generator further comprises a module for controlling the phases of the microwave sources (5) for individually adjusting the phases of the microwave sources (5) according to the adjustment of the wavelength in the given wavelength band.

*Fig. 1*

*Fig. 2*

*Fig. 3*

Fig. 4

Fig. 5

Fig. 6

Fig. 7

Fig. 8

Fig. 9

Fig. 10

Fig. 11

Fig. 12

Fig. 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- CN 205406695 U
- CN 202977681
- WO 2018016071 A
- GB 781882 A
- CN 202749491